(19) **Europäisches Patentamt / European Patent Office / Office européen des brevets**

(11) **EP 3 726 254 A1**

(12) # EUROPEAN PATENT APPLICATION
published in accordance with Art. 153(4) EPC

(43) Date of publication:
**21.10.2020 Bulletin 2020/43**

(21) Application number: **18819518.4**

(22) Date of filing: **11.12.2018**

(51) Int Cl.:
**G01T 1/24** *(2006.01)*

(86) International application number:
**PCT/CN2018/120346**

(87) International publication number:
**WO 2019/114707 (20.06.2019 Gazette 2019/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.12.2017 CN 201711315636**

(71) Applicants:
• **Tsinghua University**
  **Beijing 100084 (CN)**
• **Nuctech Company Limited**
  **Beijing 100084 (CN)**

(72) Inventors:
• **LI, Yulan**
  **Beijing 100084 (CN)**
• **LI, Hong**
  **Beijing 100084 (CN)**
• **CHANG, Jianping**
  **Beijing 100084 (CN)**
• **ZHANG, Zhi**
  **Beijing 100084 (CN)**
• **LI, Jianmin**
  **Beijing 100084 (CN)**

(74) Representative: **Cabinet Beau de Loménie**
  **158, rue de l'Université**
  **75340 Paris Cedex 07 (FR)**

(54) **HIGH-PURITY GERMANIUM DETECTOR**

(57)     The present disclosure provides a high-purity-germanium detector. The high-purity-germanium detector includes: an array of high-purity germanium crystal units including two or more high-purity germanium crystal units, wherein, each of the two or more high-purity germanium crystal units comprises a partial electrode on a side surface and/or a first top surface, and the electrodes on the side surfaces and/or the first top surfaces of the two or more high-purity germanium crystal units are electrically connected together to form a first contact electrode of the high-purity-germanium detector; and each of the high-purity germanium crystal units comprises a respective second contact electrode therein, such that the high-purity-germanium detector comprises two or more second contact electrodes.

Fig. 1

**Description**

TECHNICAL FIELD

The present disclosure relates to the field of nuclear detection technology, and in particular, to a high-purity-germanium (Ge) detector.

BACKGROUND

A high-purity-germanium detector is a semiconductor detector made of germanium single crystal with an impurity concentration in the range of $10^9 cm^{-3}$ to $10^{10} cm^{-3}$, mainly used for measurements of gamma rays and X-rays. This type of detector has a very high energy resolution and relatively high detection efficiency, and is widely used in many fields such as environmental protection, nuclear power, biomedicine, health disease control, military defense and scientific research.

The detection efficiency of the high-purity-germanium detector is generally expressed by relative detector efficiency, which is defined as a ratio of a count rate of the high-purity-germanium detector to a count rate of a 3"x3" NaI(Tl) detector in case that a $^{60}$Co source is placed 25cm directly above an end face of the high-purity-germanium detector and the energy peak is 1.33MeV. The relative detector efficiency is mainly determined by the volume of high-purity-germanium crystal, and is slightly different due to the shapes (mainly to the diameter-height ratio) of the crystals. In the case of neglecting the slight difference due to the shape, the relative detection efficiency and the volume of high-purity-germanium crystal has the following empirical relationship of:

$$\text{relative detection efficiency } (\%) = \text{volume } (cm^3) / K,$$

where $K \approx 4.3$.

The preparation technology of large-volume, high-purity germanium crystals is extremely difficult. At present, this technology has not been realized in China, and has been provided by only a few companies in the world at very high prices. At this stage, the improvement in detection efficiency of the high-purity-germanium detector is largely limited by the preparation technology of high-purity germanium crystals.

SUMMARY

According to an aspect of the present disclosure, there is provided a high-purity-germanium detector, comprising: an array of high-purity germanium crystal units comprising two or more high-purity germanium crystal units, wherein, each of the two or more high-purity germanium crystal units comprises a partial electrode on a side surface and/or a first top surface thereof, and the partial electrodes on the side surfaces and/or the first top surfaces of the two or more high-purity germanium crystal units are electrically connected together to form a first contact electrode of the high-purity-germanium detector; and each of the high-purity germanium crystal units comprises a respective second contact electrode therein, such that the high-purity-germanium detector comprises two or more second contact electrodes.

In an embodiment, the high-purity-germanium detector of claim 1, further comprising: a first electrode connecting to the first contact electrode, and a second electrode respectively connecting to the two or more second contact electrodes on a second top surface of each of the high-purity germanium crystal units; the second top surface of each of the high-purity germanium crystal units being opposite to the first top surface.

In an embodiment, the two or more high-purity germanium crystal units are configured to operate under a same bias voltage.

In an embodiment, the high-purity-germanium detector further includes: two or more charge sensitivity preamplifiers each configured to read and convert a charge signal generated by one corresponding high-purity germanium crystal unit; and a digital multichannel spectrometer configured to filter and shape a voltage signal from each of charge sensitivity preamplifiers, and to extract an amplitude information and acquire a channel address h of the voltage signal while recording a number i of the channel address, so as to acquire a synthetic spectrum of the signals of the two or more high-purity germanium crystal units.

In an embodiment, the digital multichannel spectrometer comprises a correction coefficient calibration module configured to form a spectrum for a channel i corresponding to the respective high-purity germanium crystal unit, and to automatically seek a peak to obtain a peak position channel address Pij and then acquire for each channel i, by using a first channel as a reference and fitting a data point $(P_{ij}, P_{1j})$ (j=1, 2, ..., k) with a formula $P_1 = a_i \times P_i + b_i$, a fitting parameter $[a_i, b_i]$ serving as a channel address correction coefficient of the channel i, where i is a positive integer, the first channel is any one of the channels, j=1, 2, ..., k, k is the number of peaks, and k≥2.

In an embodiment, the digital multichannel spectrometer comprises a whole spectrum generation module configured to retrieve, according to the input channel number i of each signal, a corresponding channel address correction parameter $[a_i, b_i]$; to correct the channel address h into $h' = a_i \times h + b_i$, where h' is accumulated; and to display the synthetic spectrum of the two or more high-purity germanium crystal units in real time.

In an embodiment, at least two single-energy rays are selected as a source of incidence before implementing each measurement.

In an embodiment, each of the charge sensitivity preamplifiers adopts a resistive feedback mode, a transistor feedback mode or an optical pulse feedback mode.

In an embodiment, a first voltage, which is configured as a positive high voltage for a P-typed array of high-purity germanium crystal units and is configured as a negative high voltage for a N-typed array of high-purity germanium crystal units, is applied on the first electrode; and, the second electrode is connected to the charge sensitivity preamplifier, and an input voltage level of the charge sensitivity preamplifier, which serves as a second voltage, is applied on the second electrode.

In an embodiment, the two or more high-purity germanium crystal units are assembled together in a cartridge.

In an embodiment, the cartridge is made of conductive material.

In an embodiment, the high-purity-germanium detector consisting of the two or more high-purity germanium crystal units has a symmetrical or regular shape.

In an embodiment, the array of high-purity germanium crystal units comprises three high-purity germanium crystal units each having a 120-degree corner, and the 120-degree corner of each of the high-purity germanium crystal units has two corner surfaces;

wherein, vertexes of the three 120-degree corners of the three high-purity germanium crystal units are in contact with each other, and the corner surfaces of the adjacent 120-degree corners of the three high-purity germanium crystal units are abutted against one another.

In an embodiment, the array of high-purity germanium crystal units comprises four high-purity germanium crystal units in which, two of the high-purity germanium crystal units each has a 120-degree corner while the other two of the high-purity germanium crystal units each has two 120-degree corners, and the 120-degree corners of the four high-purity germanium crystal units are abutted against each other.

In an embodiment, the array of high-purity germanium crystal units comprises seven high-purity germanium crystal units in which, a central one of the high-purity germanium crystal units has a regular hexagonal shape, and the rest of the high-purity germanium crystal units each has two 120-degree corners and are symmetrically distributed around the central one of the high purity germanium crystal units.

BRIEF DESCRIPTION OF THE DRAWINGS

Fig. 1 is a schematic view showing the structure of an array of high-purity germanium crystal units of a high-purity-germanium detector according to an embodiment of the present disclosure;

Fig. 2 is a schematic view showing the structure and the size of one high-purity germanium crystal unit of the high-purity-germanium detector according to the embodiment of the present disclosure;

Fig. 3 is a system block diagram of the high-purity-germanium detector according to the embodiment of the present disclosure;

Fig. 4 is a schematic view showing the structure of a high-purity germanium crystal unit array of a high-purity-germanium detector according to an embodiment of the present disclosure; and

Fig. 5 is a schematic view showing the structure of a high-purity germanium crystal unit array of a high-purity-germanium detector according to an embodiment of the present disclosure.

DETAILED DESCRIPTION OF THE EMBODIMENTS

While the present disclosure is susceptible to various modifications and alternative forms, the specific embodiments are illustrated in the drawings as examples. It should be understood, however, that the accompanying drawings and detailed description are not intend to construe the present invention into the specific forms disclosed, but to cover all the modifications, equivalents, and alternatives falling within the spirit and scope of the invention as defined by the appended claims. The figures are intended to be illustrative, and thus are not drawn to scale.

Terms such as "first", "second", and the like are used in this specification, and are not intended to rank or represent degrees of importance or primary and secondary relationships, but to distinguish different components. In the present specification, "top side" and "bottom side" are orientations of the upper side and the lower side of the object which are normal with respect to the normal cell.

Various embodiments of the present disclosure are described below in conjunction with the accompanying drawings.

According to embodiments of the present disclosure, there is provided a high-purity-germanium detector 100, comprising an array of high-purity germanium crystal units. The array of high-purity germanium crystal units comprises two or more high-purity germanium crystal units 101, wherein, each of the two or more high-purity germanium crystal units 101 comprises a electrode material on a side surface 101c and/or a first top surface 101a, and the electrode materials on the side surfaces 101c and/or the first top surfaces 101a of the two or more high-purity germanium crystal units 101 are electrically connected together to form a first contact electrode of the high-purity germanium detector; and each of the high-purity germanium crystal units 101 comprises a respective second contact electrode therein, such that the high-purity-germanium detector comprises two or more second contact electrodes (not shown in Figures). Here, the electrode material can be a plurality of materials which may form a PN junction with high-purity germanium crystals or may prevent high-purity germanium crystals from forming blocking contact. The contact electrode is generally formed by evaporating lithium or sputtering phosphorus ions on a high-purity germanium crystal, or by adopting another deposition process. Those skilled in the art can adopt other known processes of manufacturing the high-purity-germanium detector.

The high-purity-germanium detector further comprises a first electrode and a second electrode 103. The first electrode is connected to the first contact electrode (the first electrode is not shown in the Figures, in fact, the first electrode can be provided as needed as long as it will be electrically connected to the first contact electrode). The second electrode 103 is respectively connected to the two or more second contact electrodes on a second end surface 101b of each of the high-purity germanium crystal units 101; the second end surface 101b of each of the high-purity germanium crystal units 101 is opposite to the first top surface 101a. When measuring radiation, a first voltage is applied to the first electrode, and the first voltage is configured as a positive high voltage or a negative high voltage depending on whether the high-purity germanium crystal array is a P-type one or an N-type one. The second electrode 103 is connected to a charge sensitivity preamplifier, and an input voltage level of the charge sensitivity preamplifier is applied as the second voltage to the second electrode 103. The second contact electrode may, for example, be located at the center of each of the high-purity germanium crystal units 101, which is advantageous for collecting electron-hole pairs generated by excitation in the high-purity germanium crystal unit 101, however, this is not essential.

By arranging a plurality of high-purity germanium crystal units 101 to form an array, the limitation of low detection efficiency due to small single volume of the crystal unit can be overcome. Moreover, the use of high-purity germanium crystal units which are low in cost and small in volume can obtain a similar detection effect of a large high-purity germanium crystal, and thus reduces the product cost to some extent in the cell of similar detection efficiency.

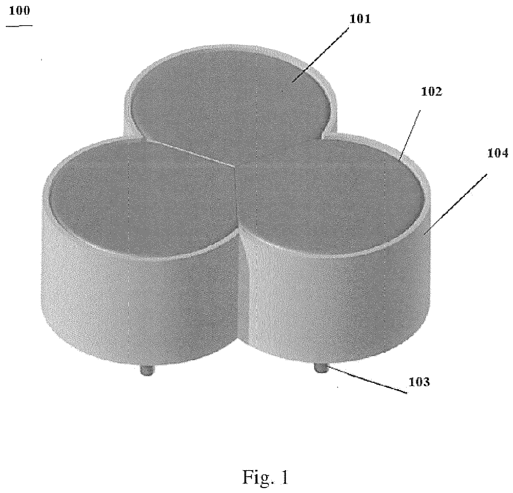

In the embodiment shown in FIG. 1, the first top surface 101a is used as a radiation/ray receiving surface, and the radiation/ray illuminates on the first top surface 101a and enters the high-purity germanium crystal unit 101, thereby exciting electron-hole pairs in the high-purity germanium crystal unit 101. The electrons and the holes drift toward the first electrode and the second electrode under the action of the electric field force formed by the first voltage and the second voltage, thereby inputting an induced charge signal into the charge sensitivity preamplifier connected to the second electrode. The first contact electrode on the first top surface 101a may be formed of a transparent conductive material.

In one embodiment, the two or more high-purity germanium crystal units 101 of the high-purity-germanium detector are configured to operate under the same bias voltage.

In another preferred embodiment, the two or more high-purity germanium crystal units 101 in the high-purity germanium detector 100 have the same shape and structure, enabling each of the crystal units to operate at the same bias voltage. In one embodiment, the two or more high-purity germanium crystal units 101 in the high-purity-germanium detector 100 have shapes that are fitted to one another such that the two or more high-purity germanium crystal units 101 can be abutted by the contact faces against one another, to have a regular shape or a centrally symmetrical shape. In a measurement, the radiation source is generally brought to be close to the detector, and the germanium detector having the symmetrical shape receives the radiation of the radiation source, and the radiation of the radiation source decreases as the propagation distance increases, so that more radiation is detected at the center of the high-purity germanium-crystal detector while less radiation is detected at the edge of the high-purity germanium-crystal detector, that is, the high-purity germanium-crystal detector having the symmetrical shape is more efficient.

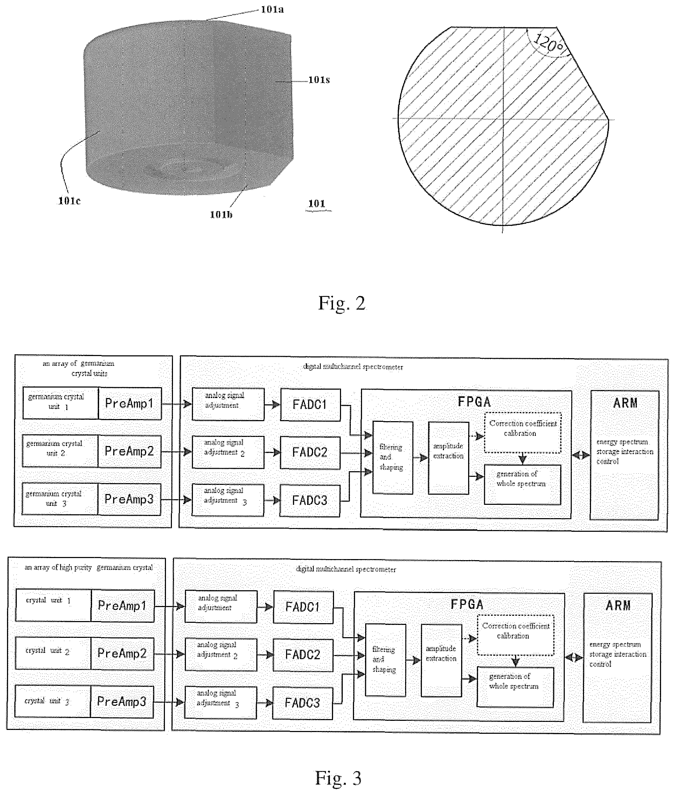

In one embodiment, as shown in Fig. 1, the array of high-purity germanium crystal units comprises three high-purity germanium crystal units 101 each having a 120-degree corner (as shown in Fig. 2), and the 120-degree corner has two corner surfaces 101s with an angle of 120 degrees therebetween. Vertexes of the three 120-degree corners of the three high-purity germanium crystal units 101 are in contact with one another, and the corner surface 101s of the 120-degree corner of one high-purity germanium crystal unit 101 is abutted against the corner surface 101s of the 120-degree corner of an adjacent high-purity germanium crystal unit 101. As shown in Fig. 1, the array of high-purity germanium crystal units comprises three high-purity germanium crystal units 101 arranged in an equilateral triangle of the central lines of the three high-purity germanium crystal units 101. A second contact electrode is formed at the center of each high-purity germanium crystal unit 101, and is respectively connected to the second electrode 103 (readout electrode). The side surface 101c and the first top surface 101a of each high-purity germanium crystal unit 101 are fabricated as electrodes and are electrically connected to each other to serve as a first contact electrode of the detector. It is advantageous to use three high-purity germanium crystal units 101 each including the 120-degree corner to form an array of high-purity germanium crystal units, which thus reducing the loss of the high-purity germanium crystal substrate. In this embodiment, each of the high-purity germanium crystal units 101 has a single-open end coaxial structure with a crystal having a height of 40 mm and a diameter of 66 mm. The side of the crystal is machined to form two flat side surfaces that are angled at an angle of 120°, that is, the side surface 101s of the corner serves as a splicing surface.

In another preferred embodiment, the array of high-purity germanium crystal units of the high-purity-germanium detector 100 comprises two high-purity germanium crystal units 101. A side of the crystal is machined to form a flat side surface, and the flat side surfaces of the two high-purity germanium crystal units 101 abut against each other.

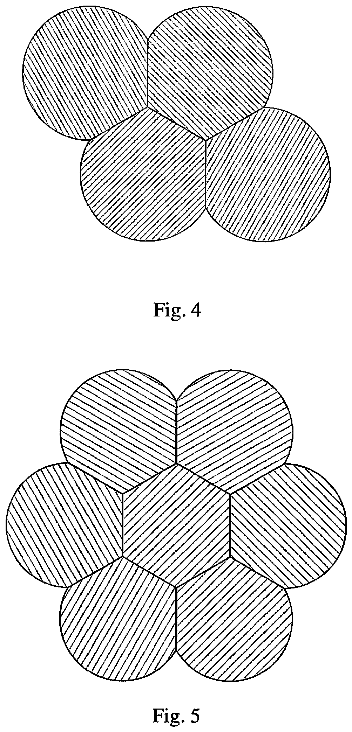

In another embodiment, the array of high-purity germanium crystal units of the high-purity-germanium detector 100 comprises four high-purity germanium crystal units 101. Fig. 4 shows a cross-sectional view of the four high-purity germanium crystal units. Referring to Fig. 4, four high-purity germanium crystal units 101 are spliced to be an array of high-purity germanium crystal units in which, two of the high-purity germanium crystal units each has a 120-degree corner while the other two of the high-purity germanium crystal units each has two 120-degree corners, and the side surfaces 101s of the 120-degree corners of the four high-purity germanium crystal units are abutted against each other.

In another embodiment, the array of high-purity germanium crystal units of the high-purity-germanium detector 100 comprises seven high-purity germanium crystal units 101. Fig. 5 shows a cross-sectional view of the seven high-purity germanium crystal units. Referring to Fig. 5, seven high-purity germanium crystal units 101 are spliced to be an array of high-purity germanium crystal units in which, a central one 101 of the high-purity germanium crystal units has a regular hexagonal shape, and the rest of the high-purity germanium crystal units each have two 120-degree corners and are symmetrically distributed around the central one 101 of the high-purity germanium crystal units.

Slash lines shown in Figs. 4 and 5 do not indicate any meaning about directions, but only indicate that Figs. 4 and 5 are cross-sectional views.

Moreover, the plurality of high-purity germanium crystal units 101 have similar impurity concentrations, which advantageously ensures that the high-purity germanium crystal units 101 have depletion voltage values that are approximate to one another, in turn reducing the difficulty of configuring the operating bias voltage for the high-purity-germanium detector 100. Therefore, the detection accuracy and the detection efficiency of the detector constituted by the plurality of high-purity germanium crystal units 101 can be improved.

In other embodiments of the present disclosure, the plurality of high-purity germanium crystal units 101 in the high-purity-germanium detector 100 are different or similar in shape, and a part of the surfaces (for example, the side surface 101c and/or the first top surface 101a) of each high-purity germanium crystal unit 101 includes electrode materials formed by sputtering or evaporation. These surfaces are electrically connected by electrode material to form a first contact electrode of the high-purity-germanium detector 100. In addition, the impurity concentration of the two or more high-purity germanium crystal units 101 in the high-purity-germanium detector 100 may also be different, as long as the requirements of the high-purity germanium crystal are satisfied; or, further, as long as the two or more high-purity germanium crystal units 101 can operate under the same bias voltage. These high-purity germanium crystal units 101 are electrically connected to form a high-purity-germanium detector 100, each crystal unit being capable of operating at the same bias voltage.

According to an embodiment of the present disclosure, the electrode material may be disposed on a side surface of the high-purity germanium crystal unit 101, and the first top surface 101a of the high-purity germanium crystal unit 101 may be a bare surface, through the contact of the side surfaces, a plurality of high-purity germanium crystal units 101 achieve electrical connection. However, in another embodiment, the electrode material may cover the side 101c and the first top surface 101a of the high-purity germanium crystal unit 101, and the radiation may pass through the electrode material into the high-purity germanium crystal.

In an embodiment of the present disclosure, the electrode material may not cover the top surface 101a of the high-purity germanium crystal unit 101. A region where no electrode material is covered is named an intrinsic region of the crystal, and the intrinsic region does not contact the first electrode (that is, the high voltage). The electrical connection of the plurality of high-purity germanium crystal units 101 can be achieved by other components. The plurality of high-purity germanium crystal units 101 electrically connected thus have first contact electrodes electrically connected together. For example, in one embodiment of the present disclosure, a plurality of high-purity germanium crystal units 101 may be assembled together in a cartridge 104, which is formed of a conductive material. The cartridge 104 assembles the plurality of high-purity germanium crystal units 101 therein together and can be used as an electrode. The cartridge 104 can be formed from a transparent, electrically conductive material.

For example, as shown in FIG. 1, the cartridge 104 is in contact with the side surfaces 101c of the plurality of high-purity germanium crystal units 101, and the side surfaces 101c or a portion thereof of the high-purity germanium crystal unit 101 is vapor-deposited or sputtered with an electrode material. In the embodiment of Fig. 1, the circular outer side surface 101c and the corner side surface 101s of the plurality of high-purity germanium crystal units 101 are each vapor-deposited or sputtered with an electrode material, or, both a portion of the circular outer side surface 101c and a portion of the corner side surface 101s are vapor-deposited or sputtered with an electrode material. The electrode material may be a transparent conductive material. A cartridge formed of conductive material is advantageous, which not only can assemble a plurality of high-purity germanium crystal units 101 together, but also can realize electrical connection between the plurality of high-purity germanium crystal units 101.

By reasonably selecting the impurity concentration parameters of the high-purity germanium crystal units 101, each crystal unit can operate under the same bias voltage, that is, the entire detector can still be powered by a single high-voltage power source, and the structure is simple, and the operation is convenient and safe. It should be noted here that, the impurity concentrations of the plurality of high-purity germanium crystal units 101 may be different from one another, but are within a certain range. Those skilled in the art are aware of the range of impurity concentrations of high-purity germanium crystals generally can be, for example, up to the order of $10^{10}cm^{-3}$, or preferably up to the order of $10^9cm^{-3}$. In an embodiment of the present disclosure, the concentrations of the plurality of high-purity germanium crystal units 101 may be different from one another as long as their concentrations can be configured such that the plurality of high-purity germanium crystal units 101 can operate at the same bias voltage.

Fig. 3 is a block diagram of the high-purity-germanium detector 100 according to an embodiment of the present disclosure. The high-purity-germanium detector 100 may comprise an array of high-purity germanium crystal units, a charge sensitivity preamplifier and a digital multichannel spectrometer.

In one embodiment, the high-purity-germanium detector 100 can include two or more charge sensitivity preamplifiers each configured to read and convert a voltage signal generated by one corresponding high-purity germanium crystal unit 101. In the embodiment shown in Fig. 3, the high-purity-germanium detector 100 comprises three high-purity germanium crystal units 101, and, three corresponding charge sensitivity preamplifier PreAmp1, PreAmp2, and PreAmp3. Each of the charge sensitivity preamplifier adopts a resistive feedback mode, a transistor feedback mode or an optical pulse feedback mode.

The high-purity-germanium detector 100 can further comprise a digital multichannel spectrometer configured to filter and shape the voltage signal from each of charge sensitivity preamplifiers, and to extract an amplitude information and acquire a channel address h of the voltage signal while recording a number i of the channel address, so as to acquire a synthetic spectrum of the signals of the two or more high-purity germanium crystal units 101.

In an embodiment of the present disclosure, the digital multichannel spectrometer comprises a correction coefficient calibration module configured to form a spectrum for a channel i corresponding to the respective high-purity germanium crystal unit 101, and to automatically seek a peak to obtain a peak position channel address Pij and then acquire for each channel i, by using a first channel as a reference and fitting a data point $(P_{ij}, P_{1j})$ (j=1, 2, ..., k) with a formula $P_1 = a_i \times P_i + b_i$, a fitting parameter $[a_i, b_i]$ serving as a channel address correction coefficient of the channel i, where i is a positive integer, the first channel is any one of the channels, j=1, 2, ..., k, k is the number of peaks, and k≥2.

In an embodiment of the present disclosure, the digital multichannel spectrometer includes a whole spectrum generation module configured to retrieve, according to the channel number i of each signal, a corresponding channel address correction parameter $[a_i, b_i]$; to correct the channel address h into $h' = a_i \times h + b_i$, where h' is accumulated; and to display the synthetic spectrum of the two or more high-purity germanium crystal units in real time.

In an embodiment of the present disclosure, at least two single-energy rays are selected as the source of incidence before implementing each measurement. The correction coefficient calibration module is configured to form a spectrum for a channel i corresponding to the respective high-purity germanium crystal unit 101, and to automatically seek a peak to obtain a peak position channel address Pij and then acquire for each channel i, by using a first channel as a reference and fitting a data point $(P_{ij}, P_{1j})$ (j=1, 2, ..., k) with a formula $P_1 = a_i \times P_i + b_i$, a fitting parameter $[a_i, b_i]$ serving as a channel address correction coefficient of the channel i, where i is a positive integer, the first channel is any one of the channels, j=1, 2, ..., k, k is the number of peaks, and k≥2. It should be noted that, the first channel has no meaning of sorting.

By pre-calibrating the correction coefficient corresponding to each crystal unit, the signal channel addresses generated from different crystals can be corrected online during the spectrum measurement process, and the whole energy spectrum of the detector array can be obtained in real time.

With the structure of the high-purity-germanium detector 100 according to the embodiment of the present disclosure, the radiation response of the detector is simulated by GEANT4, and the results show that, the relative detector efficiency can reach 102%. In contrast, the relative detector efficiency of a single cylindrical crystal substrate is about 37%. Thus, embodiments of the present disclosure can achieve high detection efficiency of the large high-purity germanium crystal unit 101 by using small high-purity germanium crystal units 101, resulting in a significant reduction in the cost of the high-purity-germanium detector 100.

Although some embodiments of the present disclosure have been shown and described, it will be understood by those skilled in the art that modifications may be made to these embodiments without departing from the principles and spirit of the present disclosure, and the scope of which is defined by the claims and their equivalents.

**Claims**

1. A high-purity-germanium detector, comprising: an array of high-purity germanium crystal units comprising two or more high-purity germanium crystal units, wherein, each of the two or more high-purity germanium crystal units comprises a partial electrode on a side surface and/or a first top surface thereof, and the partial electrodes on the side surfaces and/or the first top surfaces of the two or more high-purity germanium crystal units are electrically connected together to form a first contact electrode of the high-purity-germanium detector; and each of the high-purity germanium crystal units comprises a respective second contact electrode therein, such that the high-purity-germanium detector comprises two or more second contact electrodes.

2. The high-purity-germanium detector of claim 1, further comprising: a first electrode connecting to the first contact electrode, and a second electrode respectively connecting to the two or more second contact electrodes on a second end surface of each of the high-purity germanium crystal units; the second end surface of each of the high-purity germanium crystal units being opposite to the first top surface.

3. The high-purity-germanium detector of claim 1, wherein the two or more high-purity germanium crystal units are configured to operate under a same bias voltage.

4. The high-purity-germanium detector of claim 1, further comprising:

   two or more charge sensitivity preamplifiers each configured to read and convert a charge signal generated by one corresponding high-purity germanium crystal unit; and
   a digital multichannel spectrometer configured to filter and shape a voltage signal from each of charge sensitivity preamplifiers, and to extract an amplitude information and acquire a channel address h of the voltage signal while recording a number i of the channel address, so as to acquire a synthetic spectrum of the signals of the two or more high-purity germanium crystal units.

5. The high-purity germanium detector of claim 4, wherein the digital multichannel spectrometer comprises a correction coefficient calibration module configured to form a spectrum for a channel i corresponding to the respective high-purity germanium crystal unit, and to automatically seek a peak to obtain a peak position channel address $P_{ij}$ and then acquire for each channel i, by using a first channel as a reference and fitting a data point $(P_{ij}, P_{1j})$ (j=1, 2, ..., k) with a formula $P_1 = a_i \times P_i + b_i$, a fitting parameter $[a_i, b_i]$ serving as a channel address correction coefficient of the channel i, where i is a positive integer, the first channel is any one of the channels, j=1, 2, ..., k, k is the number of peaks, and $k \geq 2$.

6. The high-purity-germanium detector of claim 5, wherein the digital multichannel spectrometer comprises a whole spectrum generation module configured to retrieve, according to the input channel number i of each signal, a corresponding channel address correction parameter $[a_i, b_i]$; to correct the channel address h into $h' = a_i \times h + b_i$, where h' is accumulated; and to display the synthetic spectrum of the two or more high-purity germanium crystal units in real time.

7. The high-purity-germanium detector of claim 6, wherein at least two single-energy rays are selected as the source of incidence before implementing each measurement.

8. The high-purity-germanium detector of claim 4, wherein each of the charge sensitivity preamplifiers adopts a resistive feedback mode, a transistor feedback mode or an optical pulse feedback mode.

9. The high-purity-germanium detector of claim 2, wherein a first voltage, which is configured as a positive high voltage for a P-type array of high-purity germanium crystal units and is configured as a negative high voltage for a N-type array of high-purity germanium crystal units, is applied on the first electrode; and, the second electrode is connected to the charge sensitivity preamplifier, and an input voltage level of the charge sensitivity preamplifier, which serves as a second voltage, is applied on the second electrode.

10. The high-purity-germanium detector of claim 1, wherein the two or more high-purity germanium crystal units are assembled together in a cartridge.

11. The high-purity-germanium detector of claim 10, wherein the cartridge is made of conductive material.

**12.** The high-purity-germanium detector of claim 1, wherein the high-purity-germanium detector consisted of the two or more high-purity-germanium crystal units has a symmetrical or regular shape.

**13.** The high-purity-germanium detector of claim 12, wherein the array of high-purity germanium crystal units comprises three high-purity germanium crystal units each having a 120-degree corner, and the 120-degree corner of each of the high-purity germanium crystal units has two corner surfaces;
wherein, vertexes of the three 120-degree corners of the three high-purity germanium crystal units are in contact with each other, and the corner surfaces of the adjacent 120-degree corners of the three high-purity germanium crystal units are abutted against one another.

**14.** The high-purity-germanium detector of claim 12, wherein the array of high-purity germanium crystal units comprises four high-purity germanium crystal units in which, two of the high-purity germanium crystal units each has a 120-degree corner while the other two of the high-purity germanium crystal units each has two 120-degree corners, and the 120-degree corners of the four high-purity germanium crystal units are abutted against each other.

**15.** The high-purity germanium detector of claim 12, wherein, the array of high-purity germanium crystal units comprises seven high-purity germanium crystal units in which, a central one of the high-purity germanium crystal units has a regular hexagonal shape, and the rest of the high-purity germanium crystal units each has two 120-degree corners and are symmetrically distributed around the central one of the high-purity germanium crystal units.

100

101

102

104

103

Fig. 1

Fig. 2

Fig. 3

Fig. 4

Fig. 5

**INTERNATIONAL SEARCH REPORT**

| International application No. |
| --- |
| **PCT/CN2018/120346** |

| A. | CLASSIFICATION OF SUBJECT MATTER |
| --- | --- |
| | G01T 1/24(2006.01)i |

According to International Patent Classification (IPC) or to both national classification and IPC

| B. | FIELDS SEARCHED |
| --- | --- |

Minimum documentation searched (classification system followed by classification symbols)

G01T

Documentation searched other than minimum documentation to the extent that such documents are included in the fields searched

Electronic data base consulted during the international search (name of data base and, where practicable, search terms used)

CNPAT, WPI, EPODOC, CNKI: 清华大学, 同方威视技术股份有限公司, 李玉兰, 李红, 常建平, 张智, 李荐民, 锗, 探测器, 阵列, 多个, 侧面, 顶面, 接触, 偏压, 合成, high purity, germanium, detector, crystal, array, electrode

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 104749606 A (NUCTECH COMPANY LIMITED) 01 July 2015 (2015-07-01) description, paragraphs [0034]-[0049], and figures 1-5 | 1-15 |
| Y | CN 101799554 A (CHENGDU UNIVERSITY OF TECHNOLOGY) 11 August 2010 (2010-08-11) description, paragraph [0004] | 1-15 |
| PX | CN 107831525 A (TSINGHUA UNIVERSITY ET AL.) 23 March 2018 (2018-03-23) claims 1-15, and figures 1-5 | 1-15 |
| A | CN 101833106 A (LIU, JIGUO) 15 September 2010 (2010-09-15) entire document | 1-15 |
| A | CN 203965630 U (ENN COAL GASIFICATION MINING CO., LTD.) 26 November 2014 (2014-11-26) entire document | 1-15 |
| A | CN 101539630 A (SHANGHAI RESEARCH CENTER OF BIOMEDICAL ENGINEERING) 23 September 2009 (2009-09-23) entire document | 1-15 |
| A | US 6297506 B1 (YOUNG, J.W. ET AL.) 02 October 2001 (2001-10-02) entire document | 1-15 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **25 January 2019** | **27 February 2019** |

| Name and mailing address of the ISA/CN | Authorized officer |
| --- | --- |
| **State Intellectual Property Office of the P. R. China No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2018/120346**

| Patent document cited in search report | | | Publication date (day/month/year) | Patent family member(s) | | | Publication date (day/month/year) |
|---|---|---|---|---|---|---|---|
| CN | 104749606 | A | 01 July 2015 | US | 9261610 | B2 | 16 February 2016 |
| | | | | DE | 102014118917 | A1 | 02 July 2015 |
| | | | | US | 2015219773 | A1 | 06 August 2015 |
| CN | 101799554 | A | 11 August 2010 | None | | | |
| CN | 107831525 | A | 23 March 2018 | None | | | |
| CN | 101833106 | A | 15 September 2010 | None | | | |
| CN | 203965630 | U | 26 November 2014 | None | | | |
| CN | 101539630 | A | 23 September 2009 | US | 8692205 | B2 | 08 April 2014 |
| | | | | US | 2012056094 | A1 | 08 March 2012 |
| | | | | WO | 2010127598 | A1 | 11 November 2010 |
| | | | | CN | 101539630 | B | 25 January 2012 |
| US | 6297506 | B1 | 02 October 2001 | AU | 4529901 | A | 03 October 2001 |
| | | | | WO | 0171382 | A1 | 27 September 2001 |

Form PCT/ISA/210 (patent family annex) (January 2015)